# EUROPÄISCHE PATENTSCHRIFT

(11) **EP 2 612 546 B1**
(45) Veröffentlichungstag und Bekanntmachung des Hinweises auf die Patenterteilung: **03.12.2014**
(21) Anmeldenummer: 11749445.0
(22) Anmeldetag: 01.09.2011
(51) Int. Cl.: H05K 9/00, H01M 2/02, B32B 5/08, B32B 5/26, B32B 5/28, B32B 27/04, B32B 3/08, B32B 1/00

(54) **EMF-ABGESCHIRMTES KUNSTSTOFF-ORGANOBLECH-HYBRID-STRUKTURBAUTEIL**
EMF-SHIELDED PLASTIC ORGANO-SHEET HYBRID STRUCTURAL COMPONENT
COMPOSANT STRUCTUREL HYBRIDE EN PLASTIQUE ET TÔLE ORGANIQUE À FORCE ÉLECTROMOTRICE (EMF) BLINDÉE

(30) Priorität: 01.09.2010 EP 10174914
(43) Veröffentlichungstag der Anmeldung: 10.07.2013
(73) Patentinhaber: LANXESS Deutschland GmbH, 50569 Köln (DE)
(72) Erfinder: HASPEL, Julian, 50968 Köln (DE); SELIG, Jürgen, 50226 Frechen (DE)
(86) Internationale Anmeldenummer: PCT/EP2011/065128
(87) Internationale Veröffentlichungsnummer: WO 2012/028689

(56) Entgegenhaltungen:
- DATABASE WPI Week 200573 Thomson Scientific, London, GB; AN 2005-707736 XP002614641, & JP 2005 264097 A (SUMITOMO CHEM CO LTD) 29. September 2005 (2005-09-29) in der Anmeldung erwähnt

## Beschreibung

Die vorliegende Erfindung betrifft ein EMF-abgeschirmtes Kunststoff-Organobtech-Hybrid-Strukturbauteil, bevorzugt ein Batteriegehäuse sowie dessen Verwendung in Kraftfahrzeugen, bevorzugt in Elektrokraftfahrzeugen oder Hybridfahrzeugen. In diesem Zusammenhang bedeutet EMF elektromagnetische(s) Feld(er).

Niederfrequente elektrische und magnetische Felder (größer 0 Hertz bis 100 Kilohertz) werden vor allem durch technische Anwendungen hervorgerufen. Jeder elektrische Leiter, in dem Strom fließt, ist von einem Magnetfeld und einem elektrischen Feld umgeben. Im Alltag bedeutsam sind hauptsächlich die elektrischen und magnetischen Felder, die durch die Stromversorgung (50 Hz) und elektrifizierte Verkehrssysteme wie Eisenbahnen (16 2/3 Hz) entstehen. Aufgrund ihrer physikalischen Eigenschaften liegen im niederfrequenten Bereich elektrische und magnetische Felder entkoppelt vor.

Hochfrequente elektromagnetische Felder (> 100 kHz - 300 GHz) (HF-EMF) kommen in unserem Alltag hauptsächlich bei Anwendungen vor, die zur drahtlosen Informationsübertragung bei Rundfunk, Fernsehen, Mobilfunk und anderen Kommunikationstechnologien verwendet werden. Andere wichtige Anwendungsbereiche sind die Medizin und vielfältige industrielle Prozesse. Bei den HF-EMF sind die elektrische und die magnetische Komponente in einer von der Wellenlänge abhängigen Entfernung von der Quelle sehr eng miteinander gekoppelt. Bei sehr kurzen Wellenlängen kann man daher Effekte und Wirkungen, die z.B. beim Auftreffen auf den menschlichen Körper auftreten, kaum auf die Wirkung nur einer der beiden Komponenten zurückführen.

Die in jüngster Zeit und auch in Zukunft geforderte immer höhere Leistungskraß von Batterien, insbesondere im Kraftfahrzeugbereich, führt dazu, dass diese aufgrund ihrer elektromagnetischen Felder immer mehr Einfluss auf die Bordelektronik von Fahrzeugen, insbesondere Kraftfahrzeugen, oder auf die drahtlosen Informationsübertragung Einfluss nehmen können und jene Bordelektronik bzw. Informationsübertragungselektronik ganz erheblich stören können. Auch können davon andere Anwendungsbereiche wie medizinische Geräte oder Telekommunikations- oder Navigationsgeräte betroffen sein.

Aus JP 2005-264097 A ist ein spritzgegossenes Strukturbauteil zur Abschirmung elektromagnetischer Felder (EMF), etwa zur Verwendung als Gehäuseteil für Batterien in Kraftfahrzeugen bekannt, bestehend aus einem thermoplastischen Material, namentlich Polypropylen, welches durch Zusatz von Metallfasern eine hohe elektrische Leitfähigkeit aufweist.

JP 2005-264097 A beschreibt insbesondere einen spritzgegossenen Artikel aus einer Harzzusammensetzung aus Metallfasern A, einem faserigen oder cylindrischen Metall B mit niedrigerem Schmelzpunkt als A ohne dass Blei darin vorhanden ist und einem thermoplastischen Harz C.

Aufgabe der vorliegenden Erfindung war es, ein Konzept für ein EMF-abschirmendes Strukturbauteil zu erarbeiten, das eine elektrotechnische Komponente sowohl gegen äußere EMF abschirmen kann, als auch das von dieser Komponente emittierte EMF dämpfen kann, ohne Einbußen in den mechanischen Eigenschaften hinnehmen zu müssen.

Da jenes Strukturbauteil gleichzeitig aber den im heutigen Automobilbau geforderten Gewichtsbeschränkungen Rechnung tragen soll, wird eine möglichst leichte Konstruktion desselben gefordert.

Lösung der Aufgabe und somit Gegenstand der vorliegenden Erfindung ist ein EMF-abgeschirmtes Hybrid-Strukturbauteil das eine Abschirmung bzw. Dämpfung von > 50 db im Frequenzbereich von 100 MHz bis 1 GHz nach ASTM D-4935-89 gewährleistet, bevorzugt ein Batteriegehäuse, dadurch gekennzeichnet, dass dieses
a) aus einer Organoblechkomponente besteht, die ihrerseits aus einem Gewebe oder Gelege in mehreren Schichten aus einem faserförmigen Füllstoff aufgebaut ist, in das zudem noch Carbonfasern oder Metallfasern eingearbeitet sind, wobei dieses Gewebe oder Gelege in einem Thermoplasten eingebettet ist und
b) zusätzlich aus einer weiteren Kunststoff-Komponente, bevorzugt aus einem Thermoplasten, besteht, der eine hohe elektrische Leitfähigkeit aufweist

, die sich durch einen Durchgangswiderstand bis 10³ Ω cm nach ISO 3915 und einen Oberflächenwiderstand bis 10³ Ω nach IEC 60093 ausdrückt, indem bezogen auf 100 Vol.-% Gesamtfüllstoffgehalt der Kunststoff-Komponente Carbon-, Metallfasern oder Carbonanotubes im Bereich von 0,1-30 Vol.-% zugesetzt werden, wobei der Gesamtfüllstoffgehalt im Bereich von 0,1-50 Vol.-% bezogen auf 100 Vol.-% Kunststoff-Komponente liegt.

Erfindungsgemäß besteht die Organoblechkomponente aus wenigstens einem, bevorzugt einem Organoblech.

Organobleche und deren Einsatz im Kraftfahrzeugbau sind Stand der Technik.

Als Organoblech wird ein zunächst plattenförmiges Halbzeug aus faserverstärktem, thermoplastischem Kunststoff verstanden. Beispielhaft werden erfindungsgemäß einzusetzende Organobleche sowie ein Verfahren zu deren Herstellung in DE 10 2006 013 684 A1 oder in DE 10 2004 060 009 A1 beschrieben. Prepregs, ein alternativer Ausdruck für Organoblech, aus einem Textilsubstrat und Bindemittel, wobei das Bindemittel im Wesentlichen aus isolierten Punkten besteht, werden in DE 20 2004 008 122 U1 offenbart.

Der Einsatz solcher Organobleche in Form von Hohlbaugruppen für den Automobilbau ist Gegenstand der DE 10 2006 032 867 A1.

Als Instrumententafelträger im Kraftfahrzeugbereich wird der Einsatz von Organoblechen in DE 10 230 410 A1 beschrieben, ebenso ihr Einsatz als geformtes Strukturbauteil für den Karosserierohbau in DE 20 2006 019 341 U1.

DE 10 2007 047 012 A1 beschreibt den Einsatz von Organoblechen zur Herstellung eines Formkörpers, ebenso DE 10 2008 048 334 A1 und DE 10 2008 063 651 A1.

Die Verwendung eines solchen Organoblechs als Stirnwand einer Fahrzeugkabine und eines Querträgers ist Gegenstand der DE 10 2008 021 103 A1.

Ein erfindungsgemäß einzusetzendes plattenförmiges Halbzeug/Organoblech besteht aus einer thermoplastischen Matrix, die durch ein Gewebe, Gelege oder ein unidirektionales Gewebe verstärkt ist.

Bevorzugte Gewebe sind unidirektionale Gewebe. Bevorzugt bestehen die Gewebe aus Glasfasern, Aramid oder einer Mischform dieser Bestandteile. Glasfasern sind erfindungsgemäß insbesondere bevorzugt.

Erfindungsgemäß besonders bevorzugt werden Fasergewebe oder Faserfilze aus Glasfasern, die mit einer Matrix aus thermoplastischem Kunststoff umgeben sind. Für die EMF-Abschirmung werden in der Organoblechkomponente außerdem Carbon- oder Metallfasern eingesetzt. Der Gehalt an Carbonfasem oder Metallfasern in der Organoblechkomponente beträgt 0,1 Vol.-% bis 30 Vol.-%, bevorzugt 10 Vol.-% bis 30 Vol.-%, bezogen auf den Gesamtfasergehalt, wobei der Gesamtfasergehalt im Bereich von 30 Vol.-% bis 60 Vol.-%, bezogen auf 100 Vol.-% Organoblech, liegt. Bevorzugt werden als Metallfasern Stahlfasern eingesetzt.

Die Carbon- oder Metallfasern werden in der Organoblechkomponente eingesetzt, um die für die Batterietechnik nötige elektromagnetische Abschirmwirkung zu erzielen. Die Carbon- oder Metallfasern werden dabei in einem Anteil zugesetzt, wie er gerade notwendig ist, um die gewünschte EM-abschirmende Eigenschaft zu erzielen. Mit herkömmlichen Organoblechen auf reiner Glasfaserbasis ließ sich keine derartige Wirkung erzielen.

Das Halbzeug/Organoblech ist mit diesem thermoplastischen Kunststoff vollständig imprägniert und konsolidiert, d.h. die Fasern sind bereits vollständig mit Kunststoff benetzt, es befindet sich keine Luft im Material und das Halbzeug wird lediglich durch Erwärmen und anschließendes Pressen in kurzen Zykluszeiten zu dreidimensionalen Bauteilen umgeformt. Während der Umformung durchläuft der Werkstoff keine chemische Umwandlung.

Das Fasergeflecht kann nur in einer Richtung orientiert oder in zwei Richtungen in beliebigem Winkel zueinander, bevorzugt rechtwinklig zueinander orientiert sein.

In einer bevorzugten Ausführungsform werden die Fasergewebe (sehr) gerichtet (gestreckt), mit hohem Orientierungsgrad und mit einem hohen Faseranteil in die Kunststoffmatrix eingebettet.

Derart herzustellende und erfindungsgemäß zu verwendende Organobleche weisen bevorzugt Stärken von 0,3 bis 6 mm, besonders bevorzugt von 0,5 bis 3 mm auf.

Als Funktionswerkstoff kommen zur Herstellung des Organoblechs thermoplastische Kunststoffe in Frage, bevorzugt Polyamide, insbesondere aromatische Polyamide wie Polyphthalamid Polysulfon (PSU), Polyphenylensulfid (PPS), Polyphthalamide (PPA), Poly(arylenethersulfone), wie PES, PPSU oder PEI, Polyester, bevorzugt Polybutylenterephthalat (PBT) oder Polyethylenterephthalat (PET), Polypropylen (PP), Polyethylen (PE) oder Polyimide (PI). Weitere Ausführungsvarianten finden sich in DE 30 2006 013 684 A1.

Für die in der Kunststoff-Komponente b) einzusetzenden Kunststoffe kommen bevorzugt ebenfalls Thermoplaste zum Einsatz. Besonders bevorzugt werden auch hier die oben bei der Organoblech-Komponente genannten Thermoplasten eingesetzt. In einer ganz besonders bevorzugten Ausführungsform werden sowohl die Organoblech-Komponente als auch die Kunststoff-Komponente b) aus demselben thermoplastischen Material gefertigt.

Diese faserverstärkte Kunststoffmatrix der Organoblech-Komponente erfüllt im Wesentlichen die erfindungsgemäß geforderten mechanischen Eigenschaften. Weitere Funktionen wie Befestigung, Dichtung, Schutz vor flüssigen Medien und dergleichen werden u.a. aufgrund der geometrischen Komplexität durch die weitere Komponente b) abgebildet. Diese besteht erfindungsgemäß aus einem elektrisch leitfähigen Thermoplasten, der durch Gießen, vorzugsweise Spritzgießen geformt und mit der Organoblechkomponente verbunden wird. Dabei wird das wie oben beschrieben umgeformte Organoblech in ein Formwerkzeug, vorzugsweise ein Spritzgießwerkzeug, mit entsprechend gestaltetem Formhohlraum eingelegt. Anschließend wird die Kunststoff-Komponente b) eingespritzt und damit in die entsprechende Form gebracht. Ziel ist dabei, dass es zwischen dem Kunststoff der Organoblech-Komponente und dem Kunststoff, der die Komponente b) darstellt, zu einer stoffschlüssigen Verbindung kommt. Am besten erreicht man eine solche stoffschlüssige Verbindung, indem jene beiden Kunststoffe dieselbe Polymerbasis haben, insbesondere wenn beide auf einem Polyamid 6 basieren. Außerdem spielen noch Prozessparameter wie Schmelzetemperatur und Druck eine Rolle.

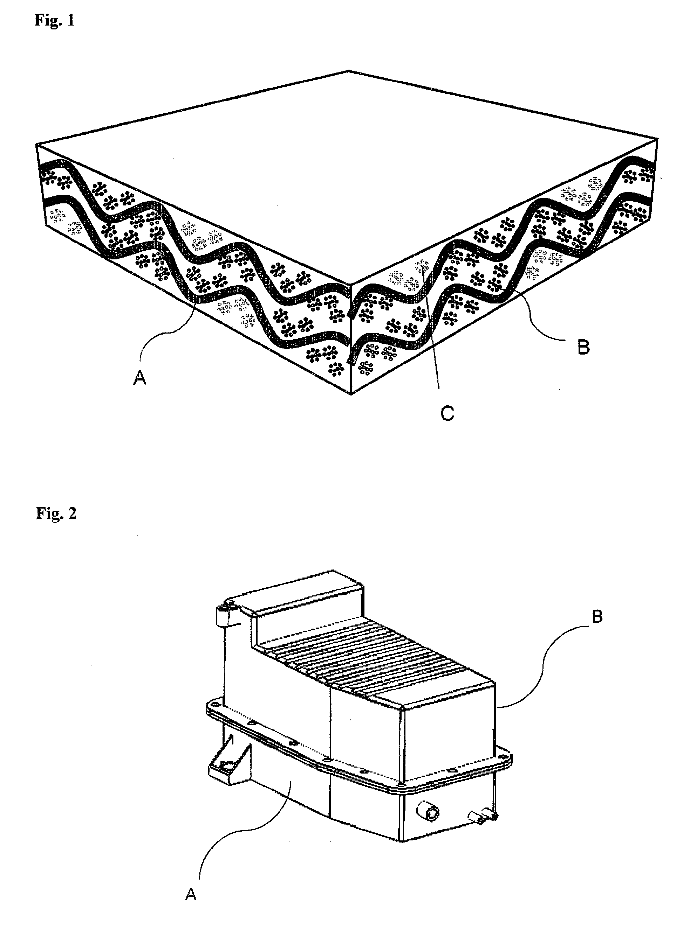

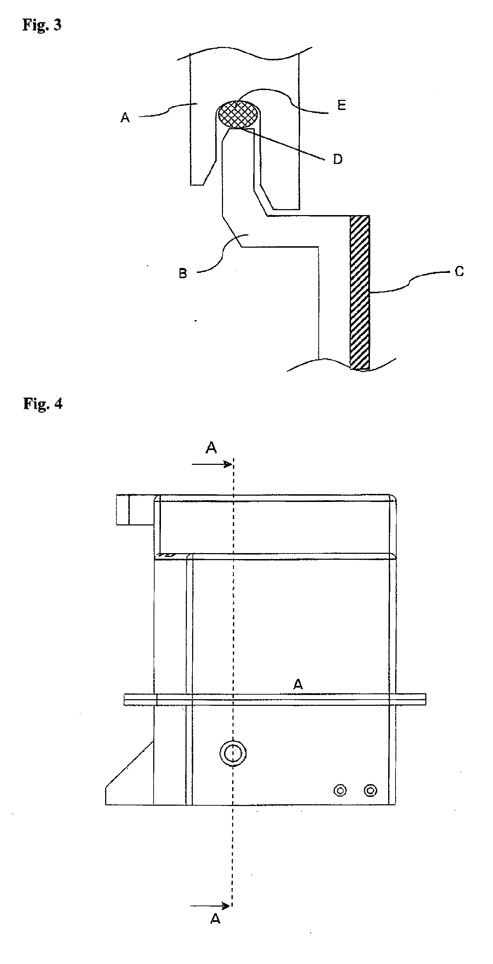

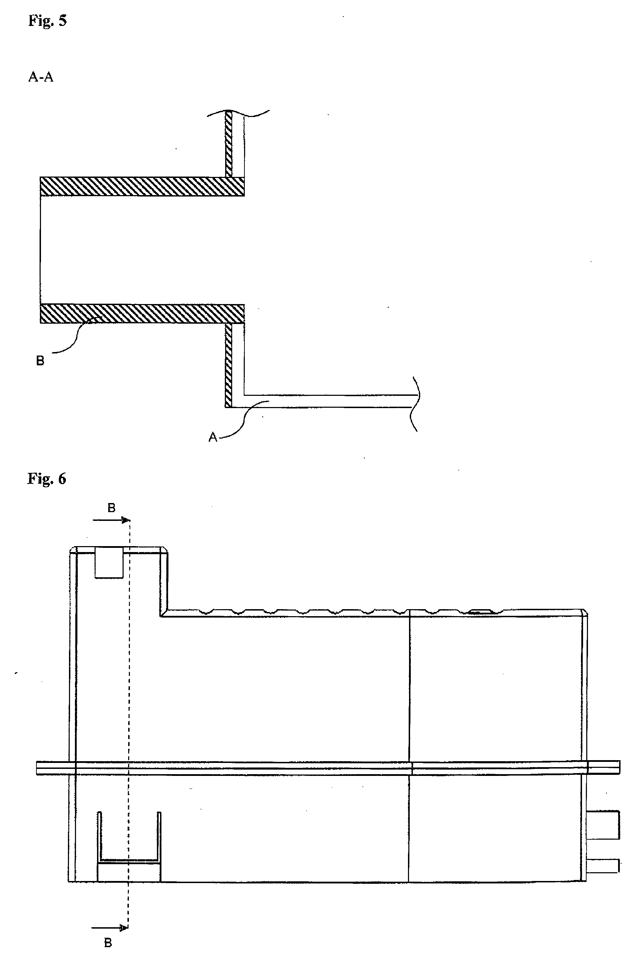

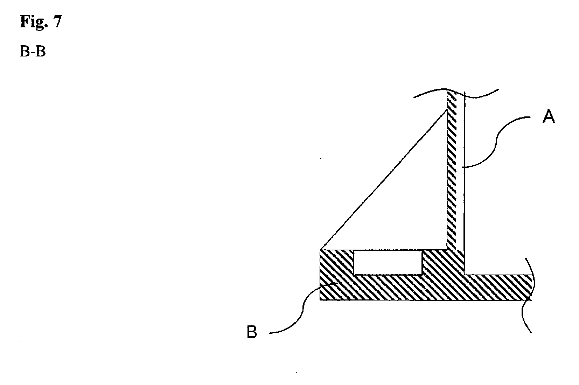

Durch die hohe elektrische Leitfähigkeit des als Komponente b) einzusetzenden Kunststoffs kann auch in solchen geometrischen Bereichen des Hybrid-Strukturbauteils, die durch das Organoblech aus prozesstechnischen Gründen schwierig darstellbar sind, eine EM-abschirmende Wirkung erzielt werden, und somit Lücken (sog. Aperturen) im EM-Schirm minimiert werden. Ein Beispiel für derartige Bereiche ist die Dichtungskontur eines Gehäuses, wie in Fig. 3 dargestellt: Beispielsweise durch den vorgegebenen Bauraum sind kleine Radien und zwei in kurzem Abstand folgende Biegungen notwendig, welche durch ein Organoblech so nicht vollständig machbar sind. Außerdem können ebene Dichtflächen, wie im Falle eines mehrteiligen Gehäuses mit Dichtung, nicht durch die Seitenfläche eines Organoblechs geformt werden. Ein weiteres Beispiel ist der Stecker-Bereich des Gehäuses aus Fig. 2 (Fig. 5), der sich in dieser oder einer ähnlichen, noch komplexeren Form, nicht durch das Organoblech formen lässt. Fig. 7 schließlich zeigt einen Befestigungsdom des Gehäuses aus Fig. 2, der sich ebenfalls nicht für eine Darstellung durch das Organoblech eignen würde. Daher werden solche geometrisch komplexen oder filigranen Bereiche durch den Funktionswerkstoff, vorzugsweise einem Thermoplasten, mit hoher elektrischer Leitfähigkeit gebildet. Mit einem solchen Werkstoff sind durch sein Verarbeitungsverhalten, vorzugsweise im Spritzguss, größere Gestaltungsfreiräume gegeben.

Die elektrische Leitfähigkeit des als Komponente b) einzusetzenden Kunststoffs, bevorzugt des Thermoplasten, wird erfindungsgemäß durch Zugabe von Carbon-, Metallfasern oder Carbonanotubes erzielt. Bezogen auf 100 Vol.-% Gesamtfüllstoffgehalt der Kunststoff-Komponente bzw. dafür einzusetzender thermoplastischer Formmassen werden Carbon-, Metallfasern oder Carbonanotubes im Bereich von 0,1 - 30 Vol.-% zugesetzt, wobei der Gesamtfüllstoffgehalt im Bereich von 0,1 bis 50 Vol.-% bezogen auf 100 Vol.-% Kunststoff-Komponente liegt.

In einer bevorzugten Ausführungsform der vorliegenden Erfindung weist das erfindungsgemäße Kunststoff-Organoblech-Hybrid-Strukturbauteil eine schalenförmige Form oder eine zylinderförmige oder eine kastenförmige Form auf. Die Form kann aber auch an die Fahrzeuggeometrie individuell angepasst werden, da ein derartiges Hybrid-Srukturbauteil ja als Batteriegehäuse erfindungsgemäß bevorzugt eingesetzt werden soll und künftige Batterien in Kraftfahrzeugen an verschiedenen Positionen lokalisiert sein können.

Darüber hinaus können im erfindungsgemäß bevorzugt als Batteriegehäuse einzusetzenden Kunststoff-Organoblech-Hybrid-Strukturbauteil zusätzliche Funktionen eingebaut sein, wie sie aus DE 10 2008 059 947 A1 oder DE 10 2008 059 955 A1 für Batteriegehäuse bekannt sind, bevorzugt Kühlplatten mit integrierten Kühlkanälen oder Wärmeleitplatten.

Ein erfindungsgemäßes EMF-abgeschirmtes Kunststoff-Organoblech-Hybrid-Strukturbauteil ist insbesondere für die Verwendung in Kraftfahrzeug-Batteriegehäusen geeignet. Diese Werkstoffe zeichnen sich durch folgende Eigenschaften aus:
- signifikant höhere Energieabsorption gegenüber einer reinen Kunststoff-Lösung, einer reinen Metallvariante, und auch gegenüber einer Kunststoff-Metall-Hybrid-Variante bei jeweils gleichem Gewicht, was im Falle eines Crash erhebliche Bedeutung für die Kraftfahrzeug-Batterie und deren Funktionsstabifität hat.
- Bauteile müssen im Vergleich mit duroplastischen, langglasfaser-verstärkten Werkstoffen nicht nachgearbeitet werden.
- Gegenüber reinen Metallblech-Varianten und Kunststoff-Metall-Hybriden ist kein Invest für Blechumformwerkzeuge nötig.
- Kunststoff-Bauteile können angeschweißt werden und am Batteriegehäuse somit weitere Funktionen eng mit diesem bzw. der Funktion der Batterie verbunden werden.

Durch die vorliegende Erfindung kann ein Kunststoff-Organoblech-Hybrid-Werkstoff zum Einen durch den gezielten Einsatz von Carbon- oder Stahlfasern im Organoblech, und zum Anderen durch den Einsatz eines elektrisch leitfähigen Kunststoffs als weiterer Komponente b) so ausgelegt werden, dass eine ausreichende EMF-Wirkung erzielt werden kann, wobei Aperturen im EM-Schirm minimiert werden können. Damit ist der Werkstoff auch für die Anwendung in automobilen Batteriegehäusen geeignet.

Eine ausreichende EMF-Wirkung im Sinne der vorliegenden Erfindung bedeutet eine Abschirmung bzw. Dämpfung von >50 db im Frequenzbereich von 100 MHz bis 1 GHz nach ASTM D-4935-89.

Andere Kunststoff-basierte Lösungen (wie z.B. elektrisch leitfähige Compounds, galvanisierte Kunststoff-Bauteile, Kunststoff-Metall-Hybride) könnten zwar (zumindest theoretisch) auch eine EMF-Wirkung entfalten. Im Vergleich bietet eine erfindungsgemäße Kunststoff-Organoblech-Hybrid-Variante aber erhebliche Vorteile:
- niedrigeres Gewicht (gegenüber Kunststoff-Metall-Hybriden, Metallblech, Aluguss)
- besseres mechanisches Verhalten, höhere Energieaufnahme (gegenüber leitfähigen, metallgefüllten Kunststoffen, Kunststoff-Metall-Hybriden)
- bessere Beständigkeit gegenüber flüssigen Medien, wie z.B. Elektrolytflüssigkeit von Batterien (gegenüber galvanisierten oder Metall-bedampften Kunststoffen).

Die vorliegende Erfindung betrifft deshalb auch die Verwendung eines Hybrid-Strukturbauteils das
a) aus einer Organoblechkomponente besteht, die ihrerseits aus einem Gewebe oder Gelege in mehreren Schichten aus einen faserförmigen Füllstoff aufgebaut ist, in das zudem noch Carbonfasern oder Metallfasern eingearbeitet sind, wobei dieses Gewebe oder Gelege in einem Thermoplasten eingebettet ist und
b) zusätzlich aus einer weiteren Kunststoff-Komponente, bevorzugt aus einem Thermoplasten, besteht, der eine hohe elektrische Leitfähigkeit aufweist, die sich durch einen Durchgangswiderstand bis 10³ Ω cm nach ISO 3915 und einem Oberflächenwiderstand bis 10³ Ω nach IEC 60093 ausdrückt, indem bezogen auf 100 Vol.-% Gesamtfüllstoffgehalt der Kunststoff-Komponente Carbon-, Metallfasern oder Carbonanotubes im Bereich von 0,1 - 30 Vol.-% zugesetzt werden, wobei der Gesamtfüllstoffgehalt im Bereich von 0,1 - 50 Vol.-% bezogen auf 100 Vol.-% Kunststoff-Komponente liegt,
zur Abschirmung elektromagnetischer Felder (EMF).

Bevorzugt betrifft die vorliegende Erfindung die Verwendung des erfindungsgemäßen Kunststoff-Organoblech-Hybrid-Strukturbauteils als EMF-abschirmendes Hybrid-Strukturbauteil in Fahrzeugen, bevorzugt in Kraftfahrzeugen.

Bevorzugte EMF-abschirmende Kunststoff-Organoblech-Hybrid Strukturbauteile im Sinne der vorliegenden Anmeldung sind neben Batteriegehäusen aber auch andere Gehäuse, die elektronische Bauteilkomponenten aufnehmen, bevorzugt Sicherungskästen, Geräte aus dem Telekommunikationsbereich oder Navigationsbereich und andere.

In einer bevorzugten Ausführungsform werden zusätzlich zu den Carbonfasem oder Metallfasern in der Organoblechkomponente als nicht-EMF-abschirmender faserförmiger Füllstoff Glasfasern oder Aramid oder eine Mischform dieser Bestandteile eingesetzt.

Zur Klarstellung sei angemerkt, dass vom Rahmen der Erfindung alle aufgeführten, allgemeineren oder in Vorzugsbereichen genannten Definitionen und Parametern in beliebigen Kombinationen umfasst sind.
Fig. 1 zeigt eine erfindungsgemäß einzusetzende Organoblechstruktur. Hierin bedeutet A = Glasfaser-Gewebe in Schnittrichtung, B = Glasfaser-Gewebe senkrecht zur Schnittrichtung und C = Metall- oder Carbonfaser-Gewebe senkrecht zur Schnittrichtung.
Fig. 2 zeigt beispielhaft ein Batteriegehäuse als Hybrid-Strukturbauteil, bestehend aus einem Unterteil (A), versehen mit Befestigungselementen und diversen Anschlüssen (z.B. für Elektrik und Kühlung), verschraubt mit einem Oberteil (B) Beide Teile werden über eine Dichtung (z.B. Elastomer-Runddichtung) im Schraub-/Flanschbereich gegen äußere Einflüsse gedichtet.
Fig. 3 zeigt einen exemplarischen Schnitt durch ein erfindungsgemäßes Hybrid-Strukturbauteil, bestehend aus einem Gehäuseoberteil (A), einem Gehäuseunterteil mit zwei Materialkomponenten (B) und (C), sowie einer Dichtung (E). Im Bereich der Umbiegungen besteht dieses Gehäuseteil aus einem elektrisch leitfähigen Kunststoff (B), mit dem auch die Dichtfläche (D) geformt wird, außerhalb dieses Bereichs besteht das Unterteil auch aus einem Organoblech (C).
Fig. 4 zeigt das Batteriegehäuse aus Fig. 2 in Frontansicht.
In Fig. 5 wird der Schnitt A-A aus Fig. 4 dargestellt, worin (B) aus einem elektrisch leitfähigen Kunststoff und (A) aus einem Organoblech besteht.
Fig. 6 zeigt das Batteriegehäuse aus Fig. 2 in einer Seitenansicht.
Fig. 7 zeigt den Schnitt B-B aus Fig. 6, wobei (B) aus einem elektrisch leitfähigen Kunststoff und (A) aus einem Organoblech besteht.

## Patentansprüche

1. EMF-abgeschirmtes Hybrid-Strukturbauteil, das eine Abschirmung bzw. Dämpfung von > 50 db im Frequenzbereich von 100 MHz bis 1 GHz nach ASTM D-4935-89 gewährleistet, **dadurch gekennzeichnet, dass** dieses
a) aus einer Organoblechkomponente besteht, die ihrerseits aus einem Gewebe oder Gelege in mehreren Schichten aus einem faserformigen Füllstoff aufgebaut ist, in das zudem noch Carbonfasern oder Metallfasern eingearbeitet sind, wobei dieses Gewebe oder Gelege in einem Thermoplasten eingebettet ist und
b) zusätzlich aus einer weiteren Kunststoff-Komponente besteht, die eine hohe elektrische Leitfähigkeit aufweist, die sich durch einen Durchgangswiderstand bis 10³ Ω cm nach ISO 3915 und einen Oberflächenwiderstand bis 10³ Ω nach IEC 60093 ausdrückt, indem bezogen auf 100 Vol.-% Gesamtfüllstoffgehalt der Kunststoff-Komponente Carbon-, Metallfasern oder Carbonanotubes im Bereich von 0,1-30 Vol.-% zugesetzt werden, wobei der Gesamtfüllstoffgehalt im Bereich von 0,1-50 Vol.-% bezogen auf 100 Vol.-% Kunststoff-Komponente liegt.

2. EMF-abgeschirmtes Hybrid-Strukturbauteil gemäß Anspruch 1, **dadurch gekennzeichnet, dass** es ein Batteriegehäuse ist.

3. EMF-abgeschirmtes Hybrid-Strukturbauteil gemäß der Ansprüche 1 oder 2, **dadurch gekennzeichnet, dass** die Kunststoff-Komponente unter b) ein Thermoplast ist.

4. EMF-abgeschirmtes Hybrid-Strukturbauteil gemäß der Ansprüche 1 bis 3, **dadurch gekennzeichnet, dass** als faserförmiger Füllstoff Glasfasern oder Aramid oder eine Mischform dieser Bestandteile eingesetzt werden.

5. EMF-abgeschirmtes Hybrid-Strukturbauteil gemäß der Ansprüche 1 bis 4, **dadurch gekennzeichnet, dass** das Fasergeflecht rechtwinklig zueinander orientiert ist.

6. EMF-abgeschirmtes Hybrid-Strukturbauteil gemäß der Ansprüche 1 bis 5, **dadurch gekennzeichnet, dass** die Organoblechkomponente aus einem Organoblech mit einer Stärke von 0,3 bis 6 mm besteht.

7. EMF-abgeschirmtes Hybrid-Strukturbauteil gemäß der Ansprüche 1 bis 6, **dadurch gekennzeichnet, dass** dieses eine schalenförmige Form oder eine zylinderförmige oder kastenförmige Form aufweist.

8. Verwendung eines Hybrid-Strukturbauteils das
a) aus einer Organoblechkomponente besteht, die ihrerseits aus einem Gewebe oder Gelege in mehreren Schichten aus einen faserförmigen Füllstoff aufgebaut ist, in das zudem noch Carbonfasem oder Metallfasern eingearbeitet sind, wobei dieses Gewebe oder Gelege in einem Thermoplasten eingebettet ist und
b) zusätzlich aus einer weiteren Kunststoff-Komponente, bevorzugt aus einem Thermoplasten, besteht, der eine hohe elektrische Leitfähigkeit aufweist, die sich durch einen Durchgangswiderstand bis 10³ Ω cm nach ISO 3915 und einen Oberflächenwiderstand bis 10³ Ω nach IEC 60093 ausdrückt, indem bezogen auf 100 Vol.-% Gesamtfüllstoffgehalt der Kunststoff-Komponente Carbon-, Metallfasern oder Carbonanotubes im Bereich von 0,1-30 Vol.-% zugesetzt werden, wobei der Gesamtfüllstoffgehalt im Bereich von 0,1-50 Vol.-% bezogen auf 100 Vol.-% Kunststoff-Komponente liegt,
zur Abschirmung elektromagnetischer Felder (EMF).

9. Verwendung gemäß Anspruch 8, **dadurch gekennzeichnet, dass** als faserförmiger Füllstoff Glasfasern oder Aramid oder eine Mischform dieser Bestandteile eingesetzt werden.

10. Verwendung gemäß Anspruch 8 oder 9, **dadurch gekennzeichnet, dass** die EMF-Abschirmung in Kraftfahrzeugen erfolgt.

11. Verwendung gemäß Anspruch 10, **dadurch gekennzeichnet, dass** es sich um ein Batteriegehäuse oder um ein Gehäuse zur Aufnahme elektronischer Bauteilkomponenten handelt.

## Claims

1. EMF-screened hybrid structural component, which ensures screening and damping of > 50 db in the frequency range from 100 MHz to 1 GHz in accordance with ASTM D-4935-89, **characterized in that** this
a) consists of an organic sheet component which, in turn, is built up from a woven fabric or laid fabric in a plurality of layers made of a fibrous filler, into which, in addition, carbon fibres or metal fibres are also incorporated, this woven fabric or laid fabric being embedded in a thermoplastic, and
b) additionally consists of a further plastic component which has a high electrical conductivity which is expressed by a volume resistance of up to 10³ Ω cm to ISO 3915 and a surface resistance of up to 10³ Ω to IEC 60093, **in that**, based on 100% by volume of total filler content of the plastic component, carbon, metal fibres or carbon nanotubes are added in the range from 0.1 - 30% by volume, the total filler content lying in the range from 0.1 - 50% by volume based on 100% by volume plastic component.

2. EMF-screened hybrid structural component according to Claim 1, **characterized in that** it is a battery housing.

3. EMF-screened hybrid structural component according to Claim 1 or 2, **characterized in that** the plastic component under b) is a thermoplastic.

4. EMF-screened hybrid structural component according to Claims 1 to 3, **characterized in that** glass fibres or aramide or a mixed form of these constituents is used as fibrous filler.

5. EMF-screened hybrid structural component according to Claims 1 to 4, **characterized in that** the fibre network is oriented at right angles to one another.

6. EMF-screened hybrid structural component according to Claims 1 to 5, **characterized in that** the organic sheet component consists of an organic sheet with a thickness of 0.3 to 6 mm.

7. EMF-screened hybrid structural component according to Claims 1 to 6, **characterized in that** this has a shell-like form or cylindrical or box-like form.

8. Use of a hybrid structural component which
a) consists of an organic sheet component which, in turn, is built up from a woven fabric or laid fabric in a plurality of layers made of a fibrous filler, into which, in addition, carbon fibres or metal fibres are also incorporated, this woven fabric or laid fabric being embedded in a thermoplastic, and
b) additionally consists of a further plastic component, preferably of a thermoplastic, which has a high electrical conductivity which is expressed by a volume resistance of up to 10³ Ω cm to ISO 3915 and a surface resistance of up to 10³ Ω to IEC 60093, in that, based on 100% by volume of total filler content of the plastic component, carbon, metal fibres or carbon nanotubes are added in the range from 0.1 - 30% by volume, the total filler content lying in the range from 0.1 - 50% by volume based on 100% by volume plastic component,
for screening electromagnetic fields (EMF).

9. Use according to Claim 8, **characterized in that** glass fibres or aramide or a mixed form of these constituents are used as a fibrous filler.

10. Use according to Claim 8 or 9, **characterized in that** the EMF screening is carried out in motor vehicles.

11. Use according to Claim 10, **characterized in that** it involves a battery housing or a housing to accommodate electronic component parts.

## Revendications

1. Composant structural hybride à blindage électromagnétique, qui assure un blindage ou un affaiblissement de > 50 db dans la plage de fréquences allant de 100 MHz à 1 GHz selon ASTM D-4935-89, **caractérisé en ce que** celui-ci
a) est constitué d'un composant tôle organique, qui est formé de son côté d'un tissu ou non-tissé en plusieurs couches d'une charge fibreuse, dans lequel des fibres carbonées ou des fibres métalliques sont en outre incorporées, ce tissu ou non-tissé étant incorporé dans un thermoplastique, et
b) est en outre constitué d'un autre composant plastique, qui présente une conductivité électrique élevée, qui se manifeste par une résistance en volume de jusqu'à 10³ Ω cm selon ISO 3915 et une résistance en surface de jusqu'à 10³ Ω selon IEC 60093, dans lequel des fibres carbonées, des fibres métalliques ou des nanotubes de carbone sont ajoutés dans la plage allant de 0,1 à 30 % en volume, par rapport à 100 % en volume de la teneur totale en charges du composant plastique, la teneur totale en charges se situant dans la plage allant de 0,1 à 50 % en volume, par rapport à 100 % en volume du composant plastique.

2. Composant structural hybride à blindage électromagnétique selon la revendication 1, **caractérisé en ce qu'**il s'agit d'un boîtier de batterie.

3. Composant structural hybride à blindage électromagnétique selon la revendication 1 ou 2, **caractérisé en ce que** le composant plastique de b) est un thermoplastique.

4. Composant structural hybride à blindage électromagnétique selon les revendications 1 à 3, **caractérisé en ce que** des fibres de verre ou d'aramide ou une forme mélangée de ces constituants sont utilisées en tant que charges fibreuses.

5. Composant structural hybride à blindage électromagnétique selon les revendications 1 à 4, **caractérisé en ce que** les tresses de fibres sont orientées perpendiculairement les unes par rapport aux autres.

6. Composant structural hybride à blindage électromagnétique selon les revendications 1 à 5, **caractérisé en ce que** le composant tôle organique est constitué d'une tôle organique d'une épaisseur de 0,3 à 6 mm.

7. Composant structural hybride à blindage électromagnétique selon les revendications 1 à 6, **caractérisé en ce que** celui-ci présente une forme en coquille ou une forme cylindrique ou une forme de boîte.

8. Utilisation d'un composant structural hybride qui
a) est constitué d'un composant tôle organique, qui est formé de son côté d'un tissu ou non-tissé en plusieurs couches d'une charge fibreuse, dans lequel des fibres carbonées ou des fibres métalliques sont en outre incorporées, ce tissu ou non-tissé étant incorporé dans un thermoplastique, et
b) est en outre constitué d'un autre composant plastique, de préférence d'un thermoplastique, qui présente une conductivité électrique élevée, qui se manifeste par une résistance en volume de jusqu'à 10³ Ω cm selon ISO 3915 et une résistance en surface de jusqu'à 10³ Ω selon IEC 60093, dans lequel des fibres carbonées, des fibres métalliques ou des nanotubes de carbone sont ajoutés dans la plage allant de 0,1 à 30 % en volume, par rapport à 100 % en volume de la teneur totale en charges du composant plastique, la teneur totale en charges se situant dans la plage allant de 0,1 à 50 % en volume, par rapport à 100 % en volume du composant plastique,
pour le blindage électromagnétique.

9. Utilisation selon la revendication 8, **caractérisée en ce que** des fibres de verre ou d'aramide ou une forme mélangée de ces constituants sont utilisées en tant que charges fibreuses.

10. Utilisation selon la revendication 8 ou 9, **caractérisée en ce que** le blindage électromagnétique a lieu dans des automobiles.

11. Utilisation selon la revendication 10, **caractérisée en ce qu'**il s'agit d'un boîtier de batterie ou d'un boîtier pour la réception de composants électroniques.
